# EUROPEAN PATENT APPLICATION

(11) **EP 0 846 983 A2**
(43) Date of publication of application: **10.06.1998**
(21) Application number: 97309669.6
(22) Date of filing: 02.12.1997
(51) Int. Cl.: G03F 7/20

(54) **Reticle transfer**

(30) Priority: 03.12.1996 JP 322760/96
(71) Applicant: NIKON CORPORATION, Tokyo (JP)
(72) Inventor: Nakahara, Kanefumi, c/o Nikon Corporation, Chiyoda-ku, Tokyo (JP)
(74) Representative: Rackham, Stephen Neil

(57) **Abstract**

A reticle case (RC) is transferred from a reticle stocker (25, Fig 6) to an exposure apparatus (27, Fig 3) by means of a reticle case transfer automated vehicle (30, Fig 6) running in a clean room. The exposure apparatus (27) includes a chamber (31), as well as a reticle case transfer device (41) and a reticle case aligning device (42) both disposed in the chamber (31). The reticle case transfer device (41) receives a reticle case (RC), at a reticle case transfer position (34), from the reticle case transfer automated guided vehicle (30) and transfers the received reticle case to the reticle case aligning device (42). The reticle case which has been aligned thereby is then transferred to a reticle storing device (or reticle library) (43). In this manner, reticle cases may be inserted into the reticle storing device (43) with a high positioning accuracy. A desired reticle, among those stored in the reticle storing device (43), is transferred therefrom onto a reticle stage (RS) of an exposure system in an automated fashion by means of a conventional reticle transfer device (46).

## Description

The present invention relates to an apparatus for and method of transferring a reticle for use with an apparatus or unit for handling reticles, such as an exposure apparatus for transferring a pattern formed on a reticle onto a substrate, a cleaning unit for cleaning reticles and an inspection unit for inspecting reticles.

In photolithographic process implemented in fabrication of semiconductor devices, liquid crystal displays or other products, there has been widely used an exposure apparatus in which an image of a pattern formed on a photomask or a reticle (a generic term "reticle" is used hereinafter to mean either) is projected and transferred through a projection optical system onto a photoresist-coated substrate such as a semiconductor wafer or a glass substrate. In a semiconductor device fabrication process, for example, several to ten and several reticles, or even more reticles may be used to perform overlay exposures so as to form a number of circuit patterns overlaid one on another on the surface of a wafer. When a reticle has to be transported or transferred for a certain purpose, the reticle is generally contained in an associated reticle case in order to prevent any contamination which could otherwise occur due to adhesion of particulates or dust floating in ambient air or by contact with the fingers of human operators, as well as from any damage which could otherwise occur when a certain object existing in the environment of the reticle happens to come into contact with it. An exposure apparatus is installed in a clean room, typically together with a reticle stocker designed for storing therein reticles, and many reticles are contained and stored in the reticle stocker.

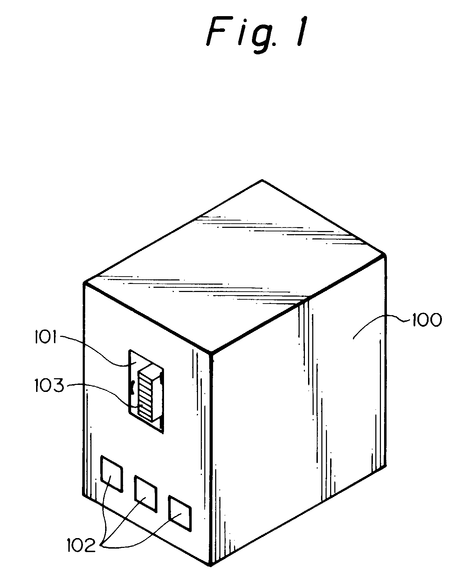

Fig. 1 is a schematic perspective view showing an appearance of a conventional exposure apparatus installed in a clean room. The exposure apparatus includes an exposure body housed in a chamber 100 which is equipped with an air-conditioning unit. With the air-conditioning, the inside of the chamber 100 is maintained at a substantially fixed environment with respect to temperature, cleanness and other factors. The chamber 100 has a reticle door 101 through which reticles are transferred into and out of the chamber 100 and wafer doors 102 through which wafers are transferred into and out of the chamber 100, all of which are provided on one of the side walls of the chamber 100. Behind the reticle door 101, there is disposed a reticle library 103 for storing therein reticles which may be used in the exposure apparatus. A human operator of the exposure apparatus takes a reticle case containing a desired reticle out of the reticle stocker disposed in the clean room, opens the reticle door 101 on the chamber 100 of the exposure apparatus, and inserts the reticle case containing the desired reticle into one of the storage locations in the reticle library 103. The operator also removes a reticle case containing a reticle having been used and no longer required from the reticle library so as to return it to the reticle stocker.

For the exposure operation, an automated reticle transfer device (or reticle loader) associated with the exposure body in the exposure apparatus takes a required reticle out of its reticle case held by the reticle library 103, and then transfers the reticle onto a reticle stage disposed above a projection optical system in an automated fashion. On the other hand, a photoresist-coated wafer is transferred through one of the wafer doors 102 into the chamber 100 of the exposure apparatus, and then transferred onto a substrate stage disposed under the projection optical system by means of an automated wafer transfer device (or wafer loader). Then, an image of a pattern formed on the reticle is transferred through the projection optical system onto the wafer.

In fabrication of semiconductor devices or other products, with the continuing reduction in linewidth of the pattern to be formed as well as the increase in complexity of the device, the influence of particulates such as dust possibly adhered to a reticle is growing greater. Any particulates adhered to a reticle will project their shadows on a wafer in addition to the shadow of the circuit pattern, which may result in defective elements and/or undesirable bridges between lines formed on a device. Because a reticle serves as a master matrix to fabricate many semiconductor chips, particulates on a reticle may result even in the failure of all the semiconductor chips fabricated using that reticle. In order to prevent adhesion of particulates onto the pattern bearing surface of a reticle, a dust-barrier membrane (or pellicle) is often used; however, a large particulate adhered on a pellicle may result in a defective circuit pattern.

So far, the transportation or transfer of a reticle (more exactly, a reticle case) from a reticle stocker for reticles to an exposure apparatus requiring that reticle has been performed as a manual operation, during which undesirable particulates may possibly adhere onto the reticle, so that great care must be taken to avoid such adhesion of particulates.

Further, such manual operation can not be free from erroneous exchange of reticles, resulting in a limited improvement in the working efficiency. In addition, such manual operation has been cumbersome and time-consuming.

It is a primary object of the present invention to provide a transfer apparatus for transferring a reticle to a process unit for handling reticles, such as an exposure apparatus for transferring a pattern formed on a reticle onto a substrate, a cleaning unit for cleaning reticles and an inspection unit for inspecting reticles.

It is another object of the present invention to provide a method of transferring a reticle to a process unit for handling reticles, such as those mentioned above.

It is a further object of the present invention to provide an exposure apparatus including a transfer apparatus for transferring a reticle.

It is a still further object of the present invention to provide a reticle case suitable for use in an automated transfer of a reticle from a reticle-storing unit to a process unit for handling reticles.

In accordance with the present invention, there is provided a transfer apparatus for transferring a reticle between a reticle stocker unit for stocking therein reticle cases each having a reticle contained therein and a reticle process unit using reticles, the transfer apparatus comprising: a first transfer device which receives a reticle case from a reticle-storing device and transfers the received reticle case to the reticle process unit, the reticle-storing device temporarily storing reticle cases on the way of transfer between the reticle stocker unit and the reticle process unit; a second transfer device which receives a reticle case sent from the reticle stocker unit and transfers the received reticle case to a first predetermined position between the reticle stocker unit and the reticle-storing device; a reticle case aligning device which alignes a reticle case transferred to the first predetermined position; and a third transfer device which transfers a reticle case which has been aligned by the reticle case aligning device to a second predetermined position.

In a preferred embodiment of the transfer apparatus, the second transfer device and the third transfer device may together comprise a single transfer device. The reticle case aligning device my comprise a reticle case supporting surface and a plurality of movable pins extending from the reticle case supporting surface, wherein the movable pins may be arranged such that they are urged onto outer peripheral edges of a reticle case placed on the reticle case supporting surface so as to accomplish alignment of that reticle case. Further, the first, second and third transfer devices may be housed in a housing, which has a visual mark provided on an outer surface thereof, wherein the visual mark is configured to be visually sensed by a sensor provided for a fourth transfer device for transferring a reticle case from the reticle stocker unit to the second transfer device.

Moreover, in a preferred embodiment, the transfer apparatus may further comprise a reticle case storing rack which temporarily stores reticle cases taken out by the third transfer device. Further, the reticle storing device may comprise i) a pair of support columns extending in the vertical direction, separated from each other, and having opposing surfaces facing to each other, ii) reticle case supporting units mounted on the opposing surfaces of the support columns, arranged one above the other separated in the vertical direction, and configured to support side portions of reticle cases such that the supported reticle cases extend substantially horizontally, and iii) reticle case securing members disposed in relation to the reticle case supporting units and cooperating with the reticle case supporting units so as to hold the side portions of reticle cases.

In accordance with the present invention, there is provided a method of transferring a reticle case, which is taken out of a reticle stocker unit for stocking therein reticle cases each having a reticle contained therein, to a reticle storing device for storing therein reticle cases, comprising the steps of: receiving a reticle case taken out of the reticle stocker unit; adjusting position of the received reticle case; and transferring the reticle case, the position of which has been adjusted to the reticle storing device.

In a preferred embodiment of the method, the step of adjusting the position of the received reticle case includes urging movable pins onto outer peripheral edges of the received reticle case.

In accordance with the present invention, there is provided an exposure apparatus including an exposure system which transfers an image of a pattern formed on a reticle onto a substrate by exposure, the exposure apparatus comprising: a reticle storing device which stores therein reticle cases each having a reticle contained therein; a first transfer device which transfers a reticle between the reticle storing device and the exposure system; a second transfer device which receives a reticle case coming from outside of the exposure apparatus and transfers it into the exposure apparatus; a reticle case aligning device which alignes the reticle case transferred by the second transfer device; and a third transfer device which transfers a reticle case which has been aligned by the reticle case aligning device to the reticle storing device.

In a preferred embodiment of the exposure apparatus, the reticle case aligning device may comprise a reticle case supporting surface and a plurality of movable pins extending from the reticle case supporting surface, wherein the movable pins may be arranged such that they are urged onto outer peripheral edges of the reticle case placed on the reticle case supporting surface so as to align the reticle case. Further, the exposure apparatus may further comprise a reticle case storing rack which temporarily stores therein reticle cases, wherein a reticle case coming from outside of the exposure apparatus and received by the second transfer device as well as a reticle case taken out of the reticle storing device by the third transfer device may be temporarily stored in the reticle case storing rack.

Moreover, in a preferred embodiment, the exposure apparatus may further comprise a chamber which maintains the exposure apparatus in a predetermined environment, the chamber having an opening formed therein through which the second transfer device receives a reticle case. Further, the exposure apparatus may further comprise a housing defining the chamber, the housing having an outer surface on which a visual mark is provided, the visual mark being visible from outside of the housing.

In accordance with the present invention, there is provided a reticle case which contains a reticle, comprising: a case body defining a space for containing the reticle, the case body having an opening at one of sides of the case body for communicating the space with outside of the case body; a first lid rotatably connected to the case body and covering the space; a second lid rotatably connected to the first lid and capable of closing the opening of the space; a reticle retainer member rotatably mounted on the first lid and arranged for rotation with rotation of the second lid; and guide portions formed on both sides of the case body and projecting sidewards therefrom.

The above and other objects, features and advantages of the present invention will be apparent from the following detailed description of preferred embodiments thereof, reference being made to the accompanying drawings, in which:
Fig. 1 is a schematic perspective view showing an appearance of a conventional exposure apparatus installed in a clean room;
Fig. 2 shows an exemplified reticle case with a top lid thereof in its open position;
Fig. 3 is a plan view of the reticle case of Fig. 1 with the top lid thereof in its closed position;
Fig. 4 is a perspective view, partially broken away, of a reticle transfer arm which is transferring a reticle having pellicles to be inserted into the reticle case;
Figs. 5(a) and 5(b) are sectional views of the reticle case along line A-A of Fig. 3, in which Fig. 5(a) shows the reticle case with a front lid thereof in its open position and Fig. 5(b) shows the reticle case with a reticle contained therein and with the front lid thereof in its closed position;
Fig. 6 is a schematic perspective view showing a reticle stocker, exposure apparatuses, and automated guided vehicles (AGVs) for transporting or transferring reticle cases, all disposed in a clean room;
Fig. 7 is a schematic view showing an exemplified internal arrangement for the exposure apparatus;
Fig. 8 illustrates a visual mark;
Figs. 9(a) to 9(h) show a set of plan views illustrating a sequence of operations performed by the transfer device in the exposure apparatus for transferring a reticle case;
Fig. 10 is a perspective view showing an appearance of a reticle case aligning device;
Fig. 11 is a plan view showing a reticle case placed on a reticle case supporting surface of the reticle case aligning device;
Fig. 12 is a schematic perspective view of a reticle library;
Figs. 13(a) and 13(b) illustrate a sequence of operations for inserting a reticle case into the reticle library, in which Fig. 13(a) is a side elevation of the reticle library showing the inner side of one support column as viewed in the X-direction and Fig. 13(b) is a frontal view of the reticle library as viewed from the same side as the transfer device (or in the Y-direction);
Fig. 14 is another side elevation of the reticle library illustrating the sequence of operations for inserting a reticle case into the reticle library;
Fig. 15 is a further side elevation of the reticle library illustrating the sequence of operations for inserting a reticle case into the reticle library; and
Fig. 16 is a plan view of a reticle case inserted in a storage location in the reticle library and secured thereto.

Referring now to the accompanying drawings, preferred embodiments of the present invention will be described in detail.

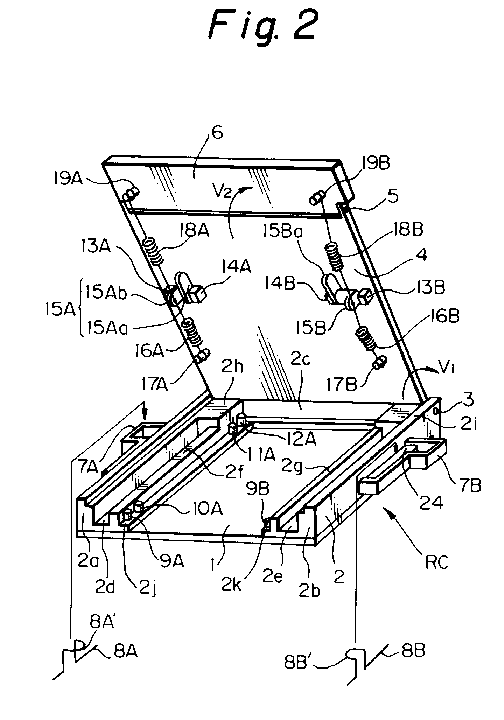

To begin with, a reticle case for containing a reticle will be described with reference to Figs. 2 to 5, by way of example. Fig. 2 shows an exemplified reticle case RC with a top lid thereof in its open position. The reticle case RC comprises a bottom plate 1 made of a suitable metal and a side wall member 2 mounted on the bottom plate 1. The side wall member 2 generally has a shape of a rectangular frame with one of the four sides removed therefrom. The reticle case RC further comprises a top lid 4 hinged to a back portion of the side wall member 2 through a pair of hinges 3 for rotational movement between its open and closed positions and a front lid 6 hinged to a front edge of the top lid 4 through a pair of hinges 5. The bottom plate 1 and the side wall member 2 are fixedly connected with each other by means of an electrically-conductive adhesive, although screws may be alternatively used to connect them with each other. The bottom plate 1 and the side wall member 2 together form a case body.

The side member 2 is a one-piece component having the back portion 2c and a pair of reticle supporting portions 2a and 2b connecting to the respective ends of the back portion 2c and extending parallel to each other as well as facing to each other. The left-hand reticle supporting portion 2a (as viewed in Fig. 2) has a ridge 2f extending in the longitudinal direction of the reticle supporting portion 2a with a deep groove 2d formed along the ridge 2f. The top surface of the reticle supporting portion 2a has a slightly-stepped or relieved area 2h in which the top lid 4 may be in abutment against the top surface of the reticle supporting portion 2a. Along the inner side of the ridge 2f there is formed a deeply-stepped or relieved area 2j. The reticle supporting portion 2a has a pair of relatively long pins or stop pins 9A and 12A fixedly mounted thereon in the deeply-relieved area 2j, as well as a pair of relatively short pins or reticle supporting pins 10A and 11A mounted thereon in the deeply-relieved area 2j and at such positions between and adjacent to the stop pins 9A and 12A, respectively.

The right-hand reticle supporting portion 2b is formed in a symmetrical shape to that of the left-hand reticle supporting portion 2a describe above, and has a deep groove 2e, a ridge 2g, a slightly-stepped or relieved area 2i in which the top lid 4 may be in abutment against the top surface of the reticle supporting portion 2b, and a deeply-stepped or relieved area 2k. The deeply-relieved area 2k extends along the inner side of the ridge 2g. A pair of stop pins 9B and 12B and a pair of reticle supporting pins 10B and 11B are fixedly mounted on the reticle supporting portion 2b in the deeply-relieved surface 2k; however, of these four pins, only one stop pins 9B is seen in Fig. 2.

A pair of guide portions 7A and 7B are formed, as integral portions of the side wall member 2, on the outer sides of the reticle supporting portions 2a and 2b, respectively. By inserting retainer springs 8A and 8B into the guide portions 7A and 7B, respectively, with the top lid 4 in abutment with the surfaces in the slightly-stepped or relieved areas 2h and 2i of the side wall member 2, the top lid 4 is urged against the side wall member 2 by the retainer springs 8A and 8B, so that the top lid 4 is retained and secured onto the side wall member 2. Each of the guide portions 7A and 7B has a recess 24 formed therein for receiving a reticle case securing pin in a reticle library. As described later in more detail, the reticle library is capable of storing a plurality of reticles each contained in an associated reticle case, and a pair of reticle case securing pins are used for securing a reticle case to the reticle library when the reticle case has been inserted in or loaded on the reticle library.

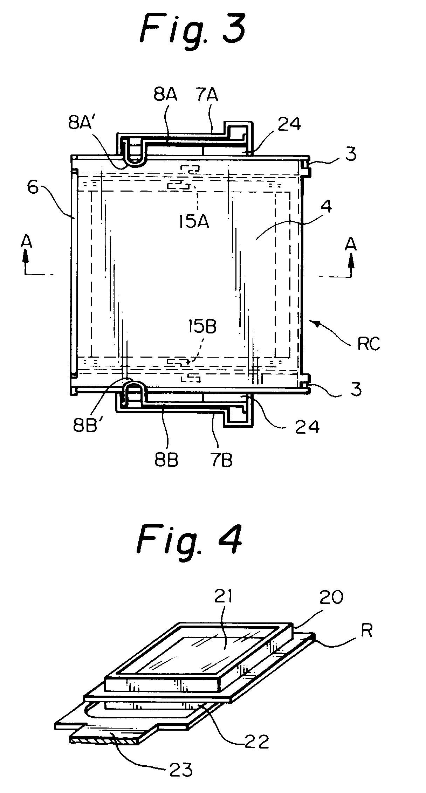

Fig. 3 is a plan view of the reticle case RC with its top lid 4 retained onto the side wall member 2 by means of the retainer springs 8A and 8B. As shown in Fig. 3, each of the retainer springs 8A and 8B has a U-shaped projection 8A' or 8B' with which the top lid 4 is urged and retained onto the side wall member 2. To open the top lid 4, the retainer springs 8A and 8B are removed from the guide portions 7A and 7B, respectively, and the top lid 4 is rotated about the axis of the pair of hinges 3. The guide portions 7A and 7B serve to guide the reticle case RC when it is inserted into or removed from a reticle-storing rack or any similar device or unit. The retainer springs 8A and 8B may be formed from suitable wire, such as piano wire, by bending a length of such wire into a desired shape.

Returning to Fig. 2, the top lid 4 has a pair of pivot supporting portions or bearing portions 13A and 14A provided on the under surface of the top lid 4 near the center of the left-hand half (as viewed in Fig. 2) of the top lid 4. A reticle retainer member 15A is disposed between and pivotally supported by the pair of pivot supporting portions 13A and 14A for rotation. The reticle retainer member 15A has a long arm or retainer arm 15Aa and a short arm or spring-engaging arm 15Ab extending in different directions forming an angle of 90 degrees between them. The top lid 4 has a spring-engaging portion 17A provided on the under surface of the top lid 4 near the rear edge (the edge adjacent to the hinges 3) of the left-hand half of the top lid 4. The front lid 6 has a spring-engaging portion 19A provided on the inner surface thereof. A helical tension spring 16A is mounted between and interconnects the spring-engaging portion 17A of the top lid 4 and the spring-engaging arm 15Ab, while another helical tension spring 18A is mounted between and interconnects the spring-engaging projection 19A of the front lid 6 and the spring-engaging arm 15Ab.

The right-hand half of the top lid 4 is formed in a symmetrical shape to that of the left-hand half thereof described above. Thus, the top lid 4 has a pair of pivot supporting portions or bearing portions 13B and 14B provided on the under surface of the top lid 4 near the center of the right-hand half thereof, as well as a reticle retainer member 15B disposed between and supported by the pair of pivot supporting portions 13B and 14B for rotation. Further, a helical tension spring 16B is mounted between and interconnects a spring-engaging portion 17B provided on the under surface of the top lid 4 and a spring-engaging arm of the reticle retainer member 15B, while another helical tension spring 18B is mounted between and interconnects a spring-engaging portion 19B provided on the inner surface of the front lid 6 and the spring-engaging arm of the reticle retainer member 15B. By virtue of this arrangement, when the front lid 6 is rotated in the direction V₂ (indicated by an arrow in Fig. 2) about the axis of the hinges 5 into its open position, the helical tension springs 16A, 16B, 18A and 18B serve to rotate the reticle retainer members 15A and 15B into such positions where their retainer arms 15Aa and 15Ba extend substantially parallel to the top lid 4. On the other hand, when the front lid 6 is rotated in the direction opposite to the direction V₂ about the axis of the hinges 5 into its closed position, the reticle retainer members 15A and 15B are rotated into such positions where their retainer arms 15Aa and 15Ba extend substantially perpendicular to the top lid 4. In this manner, a reticle contained in the reticle case RC may be retained there by means of the retainer arms 15Aa and 15Ba.

Next, we will describe an exemplified operation for inserting a reticle into the reticle case RC described above. A reticle R may be carried on a reticle transfer arm 23, as shown in Fig. 4, and transferred thereby to a position in front of the reticle case RC. The reticle R may comprise a glass substrate having its top surface covered with a very thin dust-barrier membrane (or pellicle) 21 for preventing any particulates such as dust from adhering on the top surface. The pellicle 21 is stretched across a rectangular frame 20. The under surface (or pattern bearing surface) of the glass substrate of the reticle R is also covered with a pellicle (not shown) stretched across a rectangular frame 22.

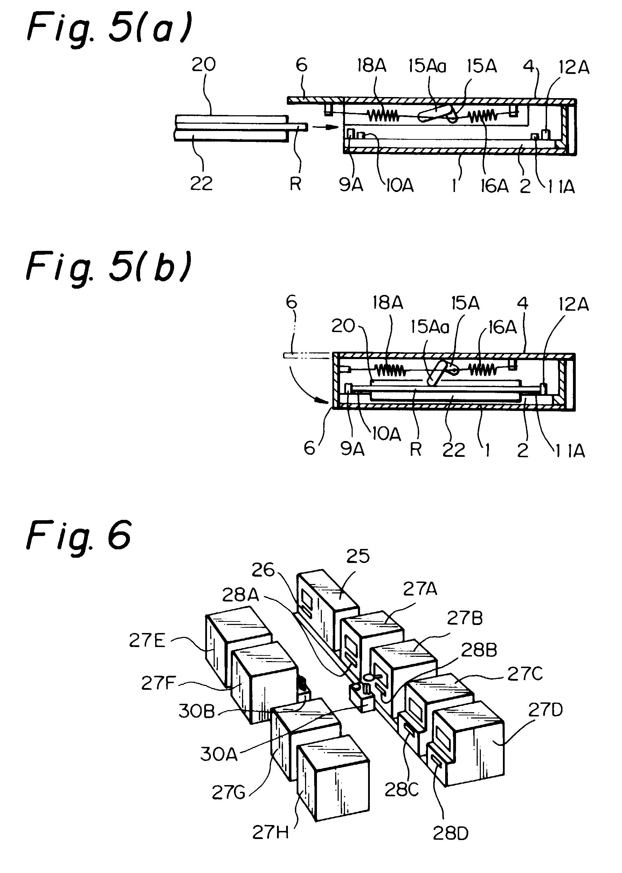

Figs. 5(a) and 5(b) are sectional views of the reticle case RC along line A-A of Fig. 3. To begin with, as shown in Fig. 5(a), the front lid 6 of the reticle case RC is rotated to open, and the reticle R with the pellicles attached thereto is inserted into the reticle case RC through the front opening of the reticle case RC. At this point of time, the reticle retainer members 15A and 15B has been rotated, by means of the helical tension springs 18A and 18B connected to the front lid 6 and the helical tension springs 16A and 16B connected to the top lid 4, into the positions where their retainer arms 15Aa and 15Ba extend substantially parallel to the top lid 4, so that they will not prevent at all the reticle R from entering into the space surrounded by the bottom plate 1, the side wall member 2 and the top lid 4.

Thereafter, as shown in Fig. 5(b), the reticle R is placed onto the pair of reticle supporting pins 10A and 11A as well as onto the pair of reticle supporting pins 10B and 11B (see Fig. 2), with the under surface of the glass substrate of the reticle R in abutment with the tip ends of the reticle-supporting pins. Then, the front lid 6 is rotated to close, with the result that the retainer arms 15Aa and 15Ba of the reticle retainer members 15A and 15B (see Fig. 2 for the member 15B) are urged against and push the top surface of the glass substrate of the reticle R so as to secure the reticle R onto the side wall member 2. As described, the stop pins 9A and 12A are provided on the outer sides of the reticle supporting pins 10a and 11A, the stop pins 9B and 12B are provided on the outer sides of the reticle supporting pins 10B and 11B, and further, the ridges 2f and 2g are provided on the outer sides of the reticle-supporting pins 10A, 10B, 11A and 11B, so that the reticle R will be kept from any significant movement within the reticle case RC during transfer of the reticle case RC. This effectively serves to prevent any damage to the pellicles and to the rectangular frames supporting the pellicles and attached to the reticle R.

Fig. 6 is a schematic perspective view showing a reticle stocker 25, exposure apparatuses 27A-27H, and automated guided vehicles (AGVs) 30A and 30B for transporting or transferring reticle cases, all disposed in a clean room. The reticle stocker 25 includes an air-conditioned chamber within which disposed is a reticle storing rack for storing therein hundreds of reticles naked or without any coverings. The exposure apparatus 27A-27H are disposed adjacent to the reticle stocker 25. Each of the exposure apparatuses 27A-27H includes a chamber, inside of which is maintained at a fixed environment by means of an associated air conditioning unit, and which contains a main body of exposure apparatus together with a reticle transfer device and a wafer transfer device associated therewith. There may be provided one or more AGVs (two AGVs 30A and 30B in the example shown) which run between the reticle stocker 25 and the exposure apparatus units 27A-27H. Any reticle required by one of the exposure apparatuses 27A-27H is transferred by either AGV 30A or 30B from the reticle stocker 25 to that exposure apparatus, while any reticle having been used and no longer required by one of the exposure apparatuses 27A-27H is returned by either AGV 30A or 30B from that exposure apparatus to the reticle stocker 25.

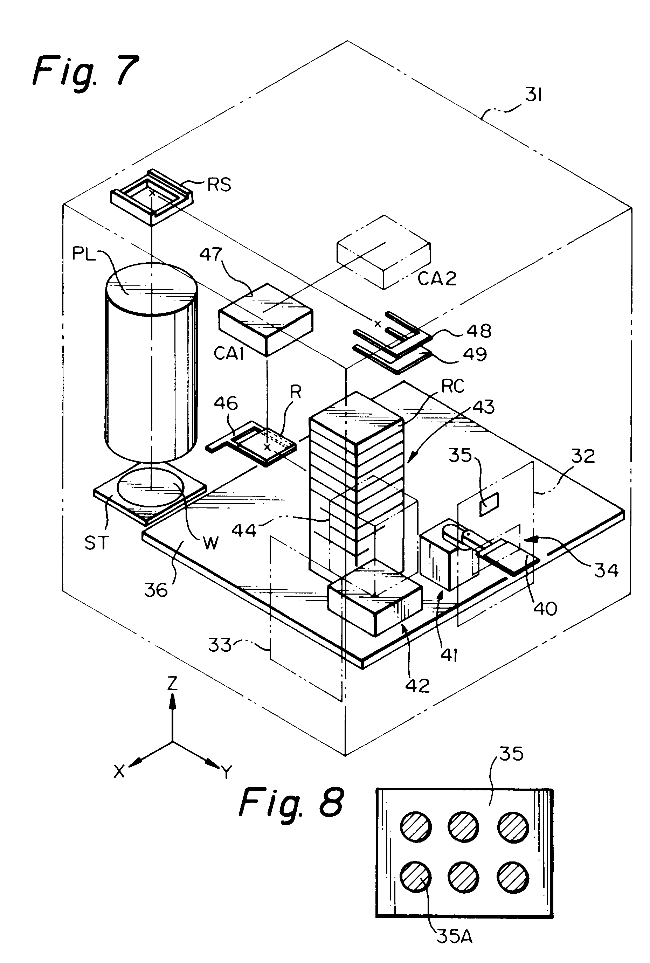

Each of the AGVs 30A and 30B includes a transfer arm having multi-degrees of freedom, which serves to pass/receive a reticle case to/from a reticle case transfer device equipped for and disposed in the reticle stocker 25. This transfer of a reticle is done through an opening formed in the chamber of the reticle stocker 25 and provided with a door 26. (Any opening provided with a door is simply referred to as "a door" hereinafter.) The transfer arm of each AGV also serves to pass/receive a reticle case to/from a transfer arm 40 (Fig. 7) equipped for and disposed within each of the exposure apparatuses 27A-27H. This transfer of a reticle is done through a door 28A, 28B,... formed in the chamber of each exposure apparatus unit. In this relation, it is noted that each of the AGVs 20A and 30B provides positional accuracy in its operation, which is only sufficient to pass/receive a reticle case to/from the transfer arm 40 of each of the exposure apparatuses 27A-27H. In fact, the positional accuracy of the AGV is much lower than that required for the transfer of a reticle case performed in each of the exposure apparatuses 27A-27H. In other words, the AGVs 30A and 30B are incapable of transferring a reticle case with such high positional accuracy with respect to the positioning of the reticle case.

When a reticle is requested by any one of apparatuses or installed in the clean room such as an exposure apparatus unit, a reticle cleaning unit or a reticle inspection unit, that reticle is taken out of the reticle stocker 25 by either reticle case transfer AGV 30A or 30B. The AGV is instructed to move to a predetermined position near the reticle stocker 25 and stand there. Then, the door 26 provided on the front wall of the reticle stocker 25 is opened, and the transfer arm (not shown) of the reticle case transfer device disposed in the reticle stocker 25 extends out of the reticle stocker 25. The AGV 30A or 30B passes an empty reticle case to the transfer arm extending out of the reticle stocker 25 through the door 26. The reticle case received by the transfer arm is then set to and held by the reticle storing rack in the reticle stocker 25, and the requested reticle among those stored in the reticle storing rack is taken out of it by an automated transfer mechanism in the reticle stocker 25 and inserted into that reticle case through an automated operation. The reticle case, now containing the requested reticle, is then returned to the AGV 30A or 30B through the transfer arm.

The reticle stocker 25 and the exposure apparatuses 27A-27H are connected with and linked to a host computer, and in accordance with the instructions from the host computer they pass/receive a reticle case to/from the AVG 30A or 30B. The AGVs 30A and 30B also communicate with the host computer by means of a suitable communication means such as wireless communication, and in accordance with the instructions from the host computer they move between the specified one of the exposure apparatuses 27A-27H and the reticle stocker 25 as well as pass/receive a reticle case to/from the reticle stocker 25 or to/from the specified exposure apparatus.

Further, the AGVs 30A and 30B communicate with a computer equipped for and controlling the reticle stocker 25, as well as with a computer equipped for and controlling each of the exposure apparatuses 27A-27H, by means of a suitable communication means such as wireless or optical communication, so as to perform the operations involved in the passing/receiving of a reticle case to/from the transfer system in the reticle stocker 25 or to/from the transfer system in each of the exposure apparatuses 27A-27H, in synchronism with the operations of such transfer system. Each of the AGVs 30A and 30B further comprises a suitable image pick device such as one using a CCD camera. Each AGV moves under automated guidance to a position in front of the exposure apparatus specified by the host computer, senses a visual mark printed at a predetermined position on the specified exposure apparatus, and uses the position of the visual mark so as to determine the reticle case transfer position at which a reticle case can be transferred (i.e., passed to or received from) the specified exposure apparatus. Then, the transfer arm of the AGV is operated to move the reticle case to that reticle case transfer position so as to pass/receive the reticle case to/from the transfer device in that exposure apparatus.

Fig. 7 is a schematic view showing an exemplified internal arrangement for the exposure apparatus according to the present invention. Fig. 7 shows only the elements and components of the reticle (or reticle case) transfer system and the exposure system, which are essential for describing the present invention, while the elements and components of the other systems including the wafer transfer system and the air-conditioning system for maintaining the inside of the chamber at a predetermined environment are omitted from the view for the sake of simplicity. In Fig. 7, the vertical direction (which is the direction of the optical axis of the projection optical system) is indicated as the Z-direction, and the other orthogonal directions are indicated as the X- and Y-directions, respectively.

The chamber 31 of the exposure apparatus has openings with doors 32 and 33, which are formed in the side walls of the chamber 31. One of the doors, 32, has a horizontally-extending elongate door 34 and a visual mark 35, which may be one shown in Fig. 8, printed on the outer surface of the door 32. Behind the door 32, there is disposed a transfer device 41 including a transfer arm 40 which is capable of extending out of the chamber 31 through the door 34. Further, the transfer arm 40 is capable of moving in the vertical direction (or the Z-direction), rotating along the XY-plane, and extending/contracting in the radial direction with respect to the axis of rotation. Near the transfer device 41, there is disposed a reticle case aligning device 42 for correcting the position of a reticle case in the X-and Y- directions as well as in the rotational direction (or the θ-direction). There is also disposed a reticle library 43 for storing therein a plurality of reticles R together with associated reticle cases RC containing the reticles R. The reticle case aligning device 42 and the reticle library 43 are mounted on a base 36.

In the chamber 31, there is also disposed the above-mentioned exposure system. The exposure system comprises an illumination optical system (not shown) for illuminating a reticle held on a reticle stage RS with an illumination light beam, a substrate stage ST for carrying a wafer W thereon and movable in the X- and Y-directions, and a projection optical system PL for projecting an image of a pattern formed on a reticle held on the reticle stage RS onto a wafer W held on the substrate stage ST. Between the reticle library 43 and the exposure system, there is disposed a reticle transfer device (or reticle loader) for transferring (or loading) a desired one of the reticles stored in the reticle library 43 onto the reticle stage RS, as well as transferring back (or loading off) a reticle having been used and no longer required from the reticle stage RS to the reticle library 43.

The reticle loader may be any of conventional reticle loaders known in the art, such as those disclosed in Japanese Laid-Open patent publications No. Hei-1-36255 (No. 36225/1989) and No. Hei-3-783 (No. 783/1991). The contents of these publications is hereby incorporated by reference. Therefore, the reticle loader will be described here only briefly. Each of the reticles R contained in the respective reticle cases RC and stored in the reticle library 43 extends horizontally. The reticle loader includes a slider 46 for taking a desired or specified reticle R out of its associated reticle case RC stored in the reticle library 43 as well as for returning a reticle R having been used into its associated reticle case RC. The slider 46 is movable in the Y- and Z-directions. In operation, the slider 46 enters into the reticle case RC, among the reticle cases held by the reticle library 43, that contains the specified reticle R. Then, the slider 46 takes the specified reticle R out of the reticle case RC by moving in a -Y-direction, then moves in a +Z-direction to the uppermost position so as to transfer the reticle R to a transfer position CA1 at which reticle transfer is performed from the slider 46 to a carrier 47.

The slider 46 has a supporting surface in which vacuum suction ports are formed. A reticle R on the supporting surface may be held thereon by turning on a vacuum pump (not shown), while it may be released therefrom by turning off the vacuum pump. The carrier 47 is movable in the X- and Z-directions, has an under surface in which vacuum suction ports are formed for holding and releasing a reticle R by vacuum suction, and capable of transferring a reticle R from the transfer position CA1 to another transfer position CA2. Further, the carrier 47 has a prealignment mechanism (not shown) for establishing prealignment of a reticle R. The prealignment mechanism uses the four side edges of a reticle R as the reference for prealignment, and sets the position of the reticle R in two orthogonal directions by gripping its side edges. The reticle loader further includes a loading arm 48 and an unloading arm 49 both of which are movable in the Y- and Z-directions. More specifically, the loading arm 48 and the unloading arm 49 may be moved independently from each other in the Y-direction between the transfer position CA2 and the reticle stage RS, while they will move together in the Z-direction. As with the slider 46, each of the loading arm 48 and the unloading arm 49 has vacuum suction ports for holding a reticle R, and turning on and off of a vacuum source communicating with the vacuum suction ports results in holding and releasing a reticle R thereon and therefrom, respectively.

Next, operation of the reticle transfer device (or reticle loader) of the exposure apparatus having the above arrangement will be described in detail. As described above with reference to Fig. 6, the reticle case transfer AGV 30A receives a reticle case RC containing a desired reticle R from the reticle case transfer device disposed in the reticle stocker 25, and moves or runs, in accordance with the instructions from the host computer, to a position in front of the exposure apparatus to which the reticle case is to be passed. A visual mark 35 is formed on the outer wall of the chamber of the exposure apparatus unit. The visual mark 35 may be a set of dots 35A such as shown in Fig. 8, may be a set of rings, or may have any of various other forms. The reticle case transfer AGV 30A performs image pick-up of the visual mark 35 by means of the image pick-up device and uses the position of the visual mark 35 as the reference to determine a reticle case transfer position at which a reticle case can be transferred between the AGV 30A and the transfer device 41 disposed in the exposure apparatus. The computer equipped for and controlling the whole of the exposure apparatus operates the exposure apparatus in accordance with the instructions from the host computer so as to open the door 34 of the chamber 31 and controls the transfer arm 40 of the transfer device 41 in the exposure apparatus to cause the transfer arm 40 to extend out of the chamber 31 to the reticle case transfer position outside the chamber 31. The reticle case transfer AGV 30A communicates with the computer for the exposure apparatus by means of a suitable communication means such as optical communication, so as to pass the reticle case (which has been transported from the reticle stocker 25) to the transfer arm 40 of the transfer device 41, with synchronized operations of the AGV 30A and the transfer arm 40.

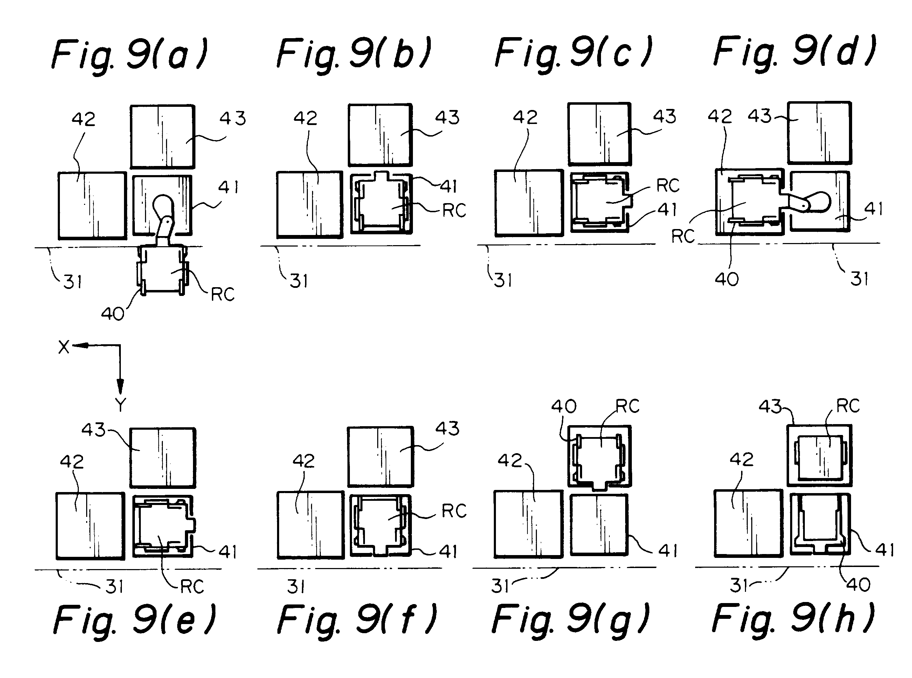

Figs. 9(a) to 9(h) show a set of plan views illustrating a sequence of operations performed by the transfer device 41 with the transfer arm 40 in the exposure apparatus for transferring a reticle case RC. Fig. 9(a) shows the reticle case RC just being transferred from one AGV to the transfer arm 40 of the transfer device 41 at the reticle case transfer position. As soon as the AGV places the reticle case RC on the transfer arm 40 of the transfer device 41, the transfer arm 40 turns on the vacuum source to hold the reticle case RC thereon by vacuum suction. Then, the transfer arm 40 returns to its home position bringing the reticle case RC into the chamber 31 as shown in Fig. 9(b), and rotates by 90 degrees in order to direct the reticle case RC toward the reticle case alinging device 42 as shown in Fig. 9(c),

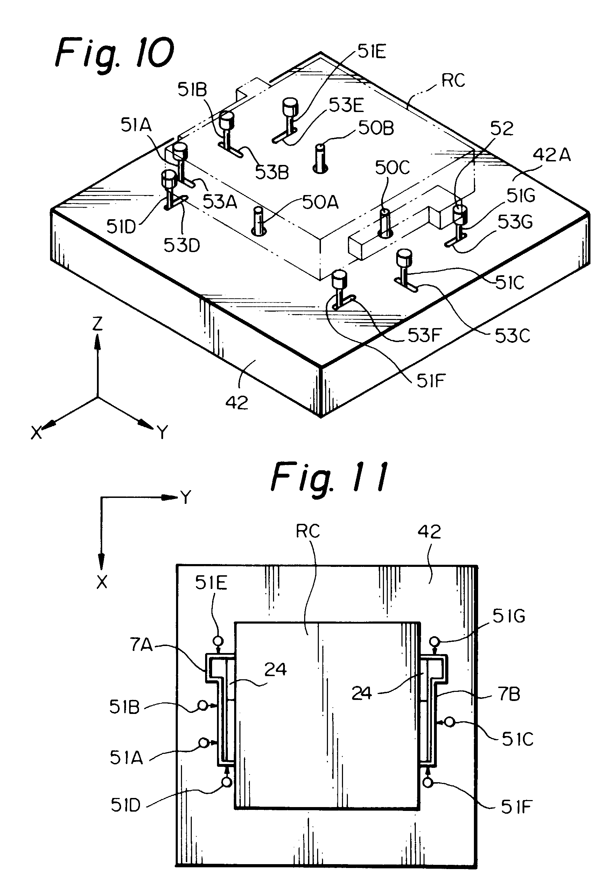

Fig. 10 is a perspective view showing the appearance of the reticle case positioning or aligning device 42. The reticle case aligning device 42 has a top surface serving as a reticle case supporting surface 42A on which the reticle case RC received from the transfer arm 40 is placed. The reticle case aligning device 42 has three reticle case transfer pins 50A, 50B and 50C and a plurality of alignment pins 51A-51G for correcting the position of the reticle case RC in the X- and Y-direction (the directions along the X-and Y-axes, respectively) and in the rotational direction about an axis along the Z-axis. The transfer pins 50A, 50B and 50C are actuated by a known actuation mechanism so as to move up/down in synchronism with each other in order to pass/receive a reticle case RC to/from the transfer arm 40. The alignment pins 51A-51G each has a roller 52 rotatably mounted thereon about an axis extending along the Z-axis. The alignment pins 51A, 51B and 51C are movable in the Y-direction along respective slots 53A, 53B and 53C extending in the Y-direction, while the alignment pins 51D, 51E, 51F and 51G are movable in the X-direction along respective slots 53D, 53E, 53F and 53G extending in the X-direction. The transfer pins 50A-50C and the alignment pins 51A-51G are driven by suitable drive units equipped for and disposed in the reticle case aligning device 42, which may comprise electric motors or air cylinders.

In order to pass the reticle case RC onto the reticle case aligning device 42, the transfer arm 40 enters a space above the reticle case aligning device 42 as shown in Fig. 9(d). Subsequently, the reticle case transfer pins 50A, 50B and 50C are displaced up so as to come into contact with the bottom surface of the reticle case RC, when then the vacuum suction used to hold the reticle case RC onto the transfer arm 40 is turned off, with the result that the reticle case RC is passed onto the reticle case transfer pins 50A, 50B and 50C. Thereafter, the transfer arm 40 moves down to leave the reticle case RC and then moves in the -X-direction to return to its home position. Then, the reticle case transfer pins 50A, 50B and 50C are displaced down to place the reticle case RC on the reticle case supporting surface 42A.

Fig. 11 is a plan view showing a reticle case placed on the reticle case supporting surface 42A of the reticle case aligning device 42. Referring next to Fig. 11, we will describe alignment of a reticle case performed by the computer equipped for each of the exposure apparatuses.

The computer for each of the exposure apparatuses controls the drive units disposed in the reticle case aligning device 42 so as to displace the alignment pins 51A and 51B in the +Y-direction to respective predetermined positions, while at the same time it displaces the alignment pin 51C in the -Y-direction to a predetermined position. Through such displacements of the alignment pins 51A-51C, the alignment pins 51A and 51B come into contact with one guide portion 7A of the reticle case RC and urge it in the +Y-direction to effect position-setting or alignment, while the third alignment pin 51C on the opposite side of the reticle case RC comes into contact with the other guide portion 7B and urges it in the -Y-direction to effect alignment. As the result, the position of reticle case RC in the Y-direction as well as in the θ-direction (or the rotational direction about an axis parallel to the Z-axis) is set to a predetermined position, that is, the position-setting or alignment of the reticle case RC in the Y- and θ-directions is accomplished.

Thereafter, the computer for the exposure apparatus displaces the alignment pin 51D in the -X-direction to a predetermined position while the alignment pin 51E in the +X-direction to a predetermined position so as to set the position of one guide portion 7A in the X-direction. At the same time, it also displaces the alignment pin 51F in the -X-direction to a predetermined position while the alignment pin 51G in the +X-direction to a predetermine position so as to set the position of the other guide portion 7B in the X-direction. With these displacements of the alignment pins 51D, 51E, 51F and 51G, the reticle case RC will be displaced in the X-direction while it is gripped by the alignment pins 51A-51C used for setting the position of the reticle case RC in the Y- and θ-directions. However, since the alignment pins 51A-51C are in contact with the guide portions 7A and 7B of the reticle case RC through the rollers 52 rotatably mounted on the alignment pins 51A-51C, the gripping of the guide portions 7A and 7B by the alignment pins 51A-51C will never impede the alignment of the reticle case RC in the X-direction. The alignment of the reticle case RC has been thus completed.

Subsequent to the completion of the positioning or alignment of the reticle case RC effected by the reticle case aligning device 42, the computer for the exposure apparatus displaces the alignment pins 51A-51G away from the outer peripheral edges of the reticle case RC. Then, the reticle case transfer pins 50A-50C are displaced upwardly so as to lift up the reticle case RC. Then, the transfer arm 40 of the transfer device 41 is moved to a position just under the reticle case RC so as to receive the reticle case RC supported on the reticle case transfer pins 50A-50C. Having received the reticle case RC, the transfer arm 40 turns on the vacuum source so as to hold the reticle case RC thereon by vacuum suction. Then, the transfer arm 40 having the reticle case RC held thereon returns back to the home position as shown in Fig. 9(e).

At the home position, the transfer arm 40 rotates by 90 degrees to face toward the reticle library as shown in Fig. 9(f). Then, the transfer arm 40 having the reticle case RC held thereon is moved to a selected position in the Z-direction by means of a lifting or elevating shaft (not shown), so that the transfer arm 40 is set to a selected height. Thereafter, the transfer arm 40 enters a selected one of the storage locations in the reticle library 43 and turns off the vacuum source to release the reticle case RC from the vacuum suction. The transfer arm 40 then moves down to leave the reticle case RC, so that the reticle case RC is passed to and supported by a pair of reticle case supporting units provided in the reticle library 43, and then the reticle case RC is secured to the reticle library 43 by a reticle case securing mechanism provided in the reticle library 43, as described below in more detail.

The transfer arm 40, now carrying no reticle case RC thereon, returns back to the home position again as shown in Fig. 9(h), and the transfer sequence has been completed at this point of time. Thereafter, the transfer arm 40 rotates by 180 degrees to return to the position shown in Fig. 9(b). It is noted that the reverse sequence of the above transfer sequence is performed when a reticle having been used and no longer required is to be removed from the reticle library 43.

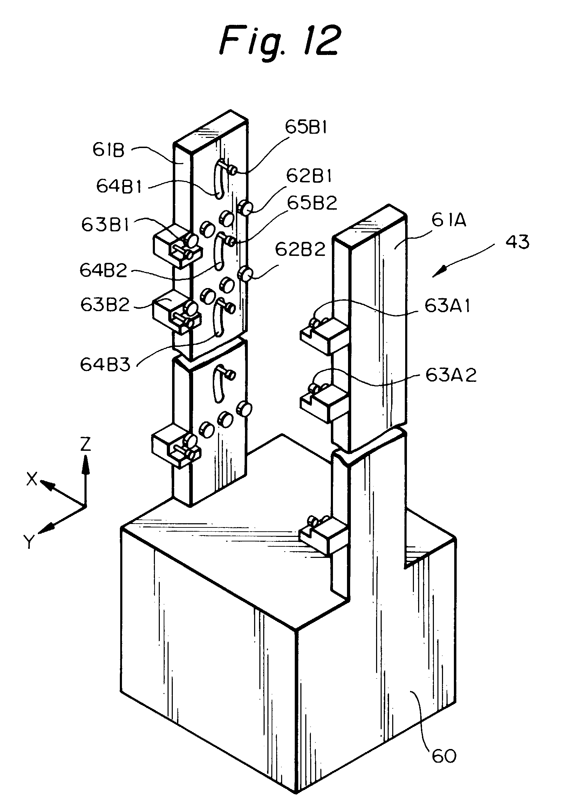

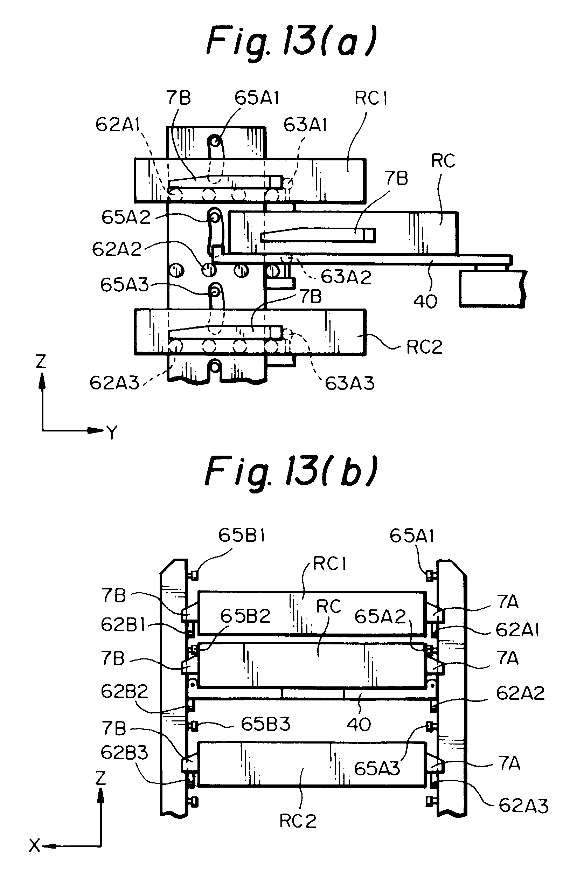

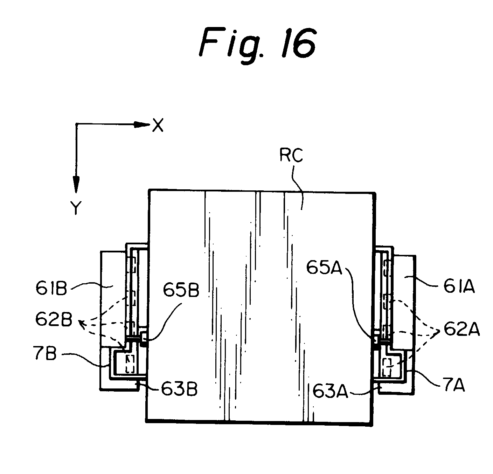

Referring next to Figs. 12 to 16, the automated reticle case securing mechanism provided in the reticle library will be described. Fig. 12 is a schematic perspective view of the reticle library, Figs. 13 to 15 are side elevations of a part of the reticle library illustrating a sequence of operations for inserting a reticle case into the reticle library, and Fig. 16 is a plan view of a reticle case inserted in a storage location in the reticle library and secured thereto.

As shown in Fig. 12, the reticle library 43 has a pair of support columns 61A and 61B extending upright on the base 60. The support columns 61A and 61B have opposing surfaces facing to each other, on which are provided: pairs of reticle case supporting units 62A1, 62B1; 62A2, 62B2;... each comprising a plurality of rollers disposed in a horizontal line; pairs of guide portion locating pins 63A1, 63Bs; 63A2, 63B2;... each having a roller at the tip end thereof; and pairs of reticle case securing pins 65A1, 65B1; 65A2, 65B2;...; wherein two elements of each pair are mounted on the two support columns 61A and 61B, respectively, at symmetrical positions. (In Fig. 13, only some of the elements mounted on the support column 61A are seen, so that not all the reference numerals for the above-mentioned elements are found in Fig. 13.) The pairs of reticle-case-securing pins 65A1, 65B1; 65A2, 65B2;... are movable up and down along respective pairs of arc-shaped slits 64A1, 64B1; 64A2, 64B2;... formed in the support columns 61A and 61B, and are so arranged as to be displaced by drive units disposed in the base 60, which may comprise electric motors, air cylinders and springs.

Next, we will describe a sequence of operations for inserting a reticle case RC into the reticle library 43 and securing it thereto.

Figs. 13(a) and 13(b) show two reticle cases RC1 and RC2 previously stored in two storage locations in the reticle library 43 and a third reticle case RC which is being stored into a storage location between the two storage locations by means of the transfer arm 40. Fig. 13(a) is a side elevation of the reticle library 43 showing the inner side of one support column 61A as viewed in the X-direction, while Fig. 13(b) is a frontal view of the reticle library 43 as viewed from the same side as the transfer device 41 (or viewed in the Y-direction). The previously stored reticle cases RC1 and RC2 are shown held in their storage locations, with the bottom surfaces of their guide portions 7A and 7B supported on the respective pairs of reticle case supporting units 62A1, 62B1 and 62A3, 62B3, and with the side protrusions of their guide portions 7A and 7B gripped by and held between i) the end surfaces of the support columns 61A and 61B and ii) the respective pairs of guide portion locating pins 63A1, 63B1 and 63A3, 63B3, so that their guide portions 7A and 7B are located in the Y-direction. The reticle case securing pins 65A1, 65B1; 65A2, 65B2;... are in their upper positions leaving the top surfaces of the corresponding guide portions 7A and 7B, resulting in that the reticle cases are released from securing.

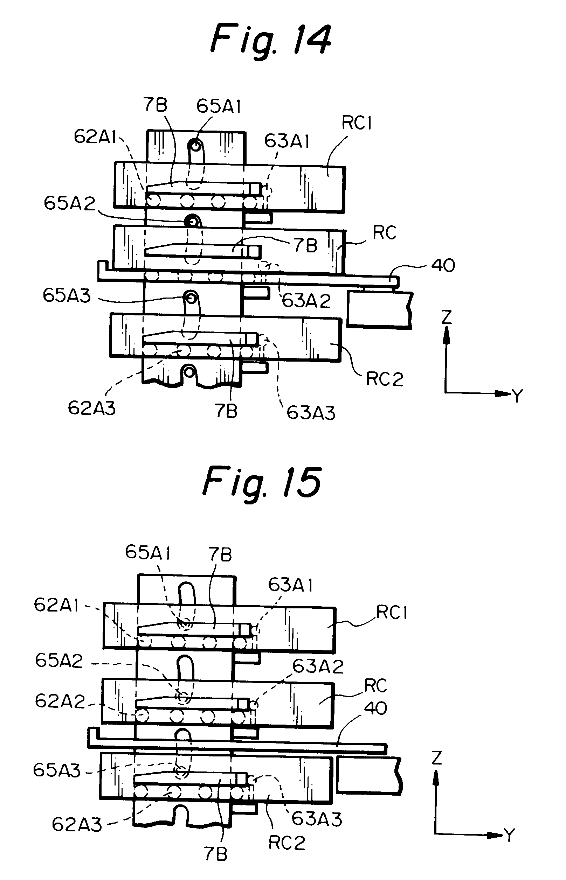

The transfer arm 40, carrying the reticle case RC held thereon by vacuum suction, moves in the -Y-direction to enter between the pair of support columns 61A and 61B, to pass through the position shown in Fig. 13 (a), and to reach the position shown in Fig. 14 where the side protrusions of the guide portions 7A and 7B of the reticle case RC are located between i) the end surfaces of the support columns 61A and 61B facing toward the transfer device 41 and ii) the pair of guide portion locating pins 63A2 and 63B2 and where the transfer arm 40 ceases its movement in the -Y-direction. Having ceased its movement, the transfer arm 40 release the reticle case RC from vacuum suction.

Then, the transfer arm 40 moves down in the -Z-direction until the bottom surfaces of the guide portions 7A and 7B of the reticle case RC come into contact with the pair of reticle case supporting units 62A2 and 62B2. Then, the drive units provided in the base 60 are operated to lift down all the pairs of reticle case securing pins 65A1, 65B1; 65A2, 65B2;... along the respective pairs of arc-shaped slits 64A1, 64B1; 64A2, 64B2;... As the result of this operation, the reticle case securing pins 65A1, 65B1; 65A2, 65B2;... come into engagement with the recesses 24 (see Fig. 2) formed in the guide portions of the reticle cases RC, RC1, RC2,... to urge the reticle cases RC, RC1, RC2,... in the downward direction as well as in the -Y-direction, so as to secure them to the support columns 61A and 61B.

Then, the transfer arm 40, having loaded the reticle case RC onto the reticle library 43, retreats in the +Y-direction to return to the home position of the transfer arm 40. As described above, for removing or unloading a reticle case RC from the reticle library 43, the reverse sequence of the above sequence of operations is performed, when the reticle case securing pins 65A1, 65B1; 65A2, 65B2;... have to be lifted up first so as to release the reticle cases from being secured. In the exemplified arrangement for the reticle case library described above, all the pairs of reticle case securing pins 65A1, 65B1; 65A2, 65B2 are moved up and down simultaneously or in synchronism; however, it may be modified such that each pair of reticle case securing pins may be moved up and down independently from the others, for releasing one particular reticle case only.

In the embodiment described above, the reticle case transfer AGVs are used for the purpose of transferring a reticle case having a reticle contained therein between the reticle stocker and one of the exposure apparatuses in the clean room, wherein the AGVs pass/receive a reticle case to/from each exposure apparatus through the front wall of the latter. However, it is not always necessary to perform the transfer of a reticle case between the AGV and the exposure apparatus through the front wall of the latter, and in fact the exposure apparatus may be modified such that the transfer of a reticle case may be performed through a side wall or a back wall of the exposure apparatus as well.

Further, in the embodiment described above, the AGVs used for transferring a reticle case between the reticle stocker and one of the exposure apparatuses is of the type designed as a vehicle running on the floor of the clean room; however, AGV systems usable with the present invention for this purpose are not limited to such type of systems. For example, an AGV system may be used which comprises a length of overhead track extending over the reticle stocker and the exposure apparatuses, and a reticle case transfer carrier designed to be guided by and run along the track by means of a suitable drive unit which may include a conventional electric motor or a linear motor. In the case where such an AGV system is used, the doors of the reticle stocker and the exposure apparatuses through which a reticle case is transferred between the AGV carrier and the reticle stocker or between the AGV carrier and the exposure apparatuses may be provided on the top walls of the reticle stocker and the exposure apparatuses. Alternatively, an AGV system may be used which comprises a length of underfloor track extending under the floor on which the reticle stocker and the exposure apparatuses are installed, and a reticle case transfer carrier designed to be guided by and run along the track. In the case where such an AGV system is used, the doors through which a reticle case is transferred may be provided on the bottom walls of the reticle stocker and the exposure apparatuses.

Referring again to Fig. 7, another embodiment of the present invention will be described. For a better understanding, let us consider first an exemplified transfer operation for transferring a plurality of reticle cases at a time between one AGV and one exposure apparatus.

In the case where a plurality of reticle cases are carried on one AGV and they are to be stored in the reticle library 43 of one exposure apparatus, the transfer operation would be such that the transfer arm 40 disposed in the exposure apparatus may repeat the sequence of operations including the steps of receiving a reticle case from the AGV, placing it on the reticle case aligning or positioning device 42 for setting its position, and storing the reticle case which has been aligned thereby into an appropriate storage location in the reticle library 43. It takes, however, a considerably long time to complete the transfer of all the reticle cases from the AGV to the reticle library 43 of the exposure apparatus with such sequence of operations, during which the AGV must continue standing at the position for reticle case transfer to/from that exposure apparatus. Similarly, in the case where a plurality of reticle cases are to be taken out of the reticle library 43 of one exposure apparatus and passed to one AGV, the transfer operation would be such that the transfer arm 40 may repeat the sequence of operations including the steps of taking a reticle case from the reticle library 43, placing it on the reticle case aligning device 42, and transferring the reticle case which has been aligned to the AGV. It also takes a considerably long time to complete the transfer of all the reticle cases with such sequence of operations, during which the AGV can not be used for any other works.

In order to overcome this inconvenience, there is provided near the reticle case aligning device 42 a reticle case storing rack 44 for temporarily storing a plurality of reticle cases therein. By virtue of the provision of the reticle case storing rack 44, when a plurality of reticle cases carried on one AGV are to be received and stored in the reticle library 43, the transfer arm 40 in the exposure apparatus unit may sequentially receive the reticle cases from the AGV and store them in the reticle case storing rack 44 without positioning or aligning the reticle cases. The AGV, having passed all the reticle cases to the transfer arm 40, can move to another position for the next work. In the exposure apparatus, on the other hand, the reticle cases temporarily stored in the reticle case storing rack 44 are then sequentially taken out of it and transferred onto the reticle case aligning device 42 to undergo alignment and then stored in appropriate storage locations in the reticle library 43.

In the reverse transfer operation, i.e., the transfer of a plurality of reticle cases from the reticle library 43 of one exposure apparatus to one AGV, the transfer arm 40 repeats the sequence of operations including the steps of taking one of the specified reticle cases out of the reticle library 43, placing it on the reticle case aligning device 42 for setting or aligning its position, and storing it in the reticle case storing rack 44, until all the specified reticle cases has been transferred to the reticle case storing rack 44. Then, the set of reticle cases thus undergone the alignment and stored in the reticle case storing rack 44 are sequentially transferred from the reticle case storing rack 44 to one AGV, so that the reticle cases may be transferred from the exposure apparatus to the AGV in a short time. As understood from the above, by virtue of the provision of the reticle case storing rack 44 which may be used for temporarily storing therein a plurality of reticle cases and which is situated at a position near the reticle case aligning device 42, the time during which the AGV has to continue standing may be shortened and the effective operation of the AGV may be facilitated.

As apparent from the above, according to the present invention, the transfer and loading of the reticle may be fully automated requiring no manual operation, so that the efficiency of the operations involved in the handling of a reticle may be improved and the productivity of the exposure apparatus may be increased. Further, emanation of any harmful particulates such as dust may be suppressed and finer patterns for various products with higher complexity may be more conveniently formed with improved yield.

Moreover, since the reticle case aligning device 42 in the exposure apparatus serves to correct any errors in the position of a reticle case relative to the transfer arm 40, so that the tolerance for the errors in the position of a reticle case when it is transferred from the AGV to the transfer arm 40 in the exposure apparatus may be less tight, resulting in a more readily transfer between the AGV and the transfer arm 40 in the exposure apparatus together with a more precise loading of a reticle case onto the reticle library 43.

While the preferred embodiments described above show exemplified uses of the present invention with exposure apparatuses, the applications of the present invention are not limited to such uses. In fact, the present invention may be also used with various other kinds of equipment or units, such as a reticle cleaning unit, a reticle inspection unit and others.

According to the present invention, all the operations involved in the handling of a reticle, including the transfer of a reticle to/from a reticle case transfer AGV, the transfer of a reticle within an exposure apparatus, and the loading of a reticle onto a reticle library, may be fully automated, so that the efficiency of the operations involved in the handling of a reticle may be improved and the productivity of the exposure apparatus may be increased.

Having described the present invention with reference to several preferred embodiments thereof, it is to be understood that the present invention is not limited to the disclosed embodiments, but may be embodied in various other forms without departing from the spirit and the scope of the present invention as defined by the appended claims.

The contents of Japanese Patent Application No. 8-322760, filed on December 3, 1996, in Japan is hereby incorporated by reference.

## Claims

1. A transfer apparatus for transferring a reticle between a reticle stocker unit for stocking therein reticle cases each having a reticle contained therein and a reticle processing unit using reticles, said transfer apparatus comprising:
a first transfer device which receives a reticle case from a reticle-storing device and transfers the received reticle case to said reticle process unit, said reticle-storing device temporarily storing reticle cases on the way of transfer between said reticle stocker unit and said reticle process unit;
a second transfer device which receives a reticle case sent from said reticle stocker unit and transfers the received reticle case to a first predetermined position between said reticle stocker unit and said reticle-storing device;
a reticle case aligning device which aligns a reticle case transferred to said first predetermined position; and
a third transfer device which transfers a reticle case which has been aligned by said reticle case aligning device to a second predetermined position.

2. A transfer apparatus according to claim 1, wherein:
said second transfer device and said third transfer device together comprise a single transfer device.

3. A transfer apparatus according to claim 1 or 2, wherein :
said reticle case aligning device comprises a reticle case supporting surface and a plurality of movable pins extending from said reticle case supporting surface, wherein said movable pins are arranged such that they are urged onto outer peripheral edges of a reticle case placed on said reticle-case-supporting surface so as to align said reticle case.

4. A transfer apparatus according to any preceding claim, wherein:
said first, second and third transfer devices are housed in a housing, which has a visual mark provided on an outer surface thereof, wherein said visual mark is configured to be visually sensed by a sensor provided for a fourth transfer device which transfers reticle case from said reticle stocker unit to said second transfer device.

5. A transfer apparatus according to any preceding claim, further comprising:
a reticle case storing rack for temporarily storing reticle cases taken out by said third transfer device.

6. A transfer apparatus according to any preceding claim, wherein:
said reticle storing device comprises i) a pair of support columns extending in the vertical direction, separated from each other, and having opposing surfaces facing to each other, ii) reticle case supporting units mounted on said opposing surfaces of said support columns, arranged one above the other separated in the vertical direction, and configured to support side portions of reticle cases such that the supported reticle cases extend substantially horizontally, and iii) reticle case securing members disposed in relation to said reticle case supporting units and cooperating with said reticle case supporting units so as to hold said side portions of reticle cases.

7. A transfer apparatus according to claim 6, wherein:
said reticle case securing members are movable up and down relative to said reticle case supporting units.

8. A method of transferring a reticle case, which is taken out of a reticle stocker unit for stocking therein reticle cases each having a reticle contained therein, to a reticle-storing device for storing therein reticle cases, comprising the steps of:
receiving a reticle case taken out of said reticle stocker unit;
adjusting the position of the received reticle case; and
transferring the reticle case which position has been adjusted to said reticle-storing device.

9. A method according to claim 8, wherein:
said step of adjusting the position of the received reticle case includes urging movable pins onto outer peripheral edges of the received reticle case.

10. An exposure apparatus including an exposure system for transferring an image of a pattern formed on a reticle onto a substrate by exposure, said exposure apparatus comprising:
a reticle storing device which stores therein reticle cases each having a reticle contained therein;
a first transfer device which transfers a reticle between said reticle-storing device and said exposure system;
a second transfer device which receives a reticle case coming from outside of said exposure apparatus and transferrs it into said exposure apparatus;
a reticle case aligning device which aligns said reticle case transferred by said second transfer device; and
a third transfer device which transfers said reticle case which has been aligned by said reticle case aligning device to said reticle-storing device.

11. An exposure apparatus according to claim 10, wherein:
said reticle case aligning device comprises a reticle case supporting surface and a plurality of movable pins extending from said reticle case supporting surface, wherein said movable pins are arranged such that they are urged onto outer peripheral edges of said reticle case placed on said reticle case supporting surface so as to align said reticle case.

12. An exposure apparatus according to claim 1 or 11, further comprising:
a reticle case storing rack which temporarily stores therein reticle cases, wherein a reticle case coming from outside of said exposure apparatus and received by said second transfer device as well as a reticle case taken out of said reticle storing device by said third transfer device may be temporarily stored in said reticle case storing rack.

13. An exposure apparatus according to claim 10, 11 or 12, further comprising:
a chamber which maintains said exposure apparatus in a predetermined environment, said chamber having an opening formed therein through which said second transfer device receives a reticle case.

14. An exposure apparatus according to claim 13, further comprising:
a housing defining said chamber, said housing having an outer surface on which a visual mark is provided, said visual mark being visible from outside of said housing.

15. A substrate processing apparatus for receiving a substrate and performing a predetermined process using said substrate, comprising:
a receiving device which receives said substrate transferred from the outside of said processing apparatus; and
an adjusting device which adjusts the position of the received substrate.

16. A substrate processing apparatus according to Claim 15, wherein said receiving device includes a temporal storage section which temporally stores a plurality of said substrates.

17. A substrate processing apparatus according to Claim 15, wherein said substrate is a reticle on which a pattern is formed.
